(19) **Europäisches Patentamt**
**European Patent Office**
**Office européen des brevets**

(11) **EP 4 694 649 A1**

(12) **EUROPEAN PATENT APPLICATION**
published in accordance with Art. 153(4) EPC

(43) Date of publication:
**11.02.2026 Bulletin 2026/07**

(21) Application number: **24781125.0**

(22) Date of filing: **21.03.2024**

(51) International Patent Classification (IPC):
*H10K 59/35* (2023.01)   *H10K 59/80* (2023.01)
*H10K 59/38* (2023.01)   *H10K 77/10* (2023.01)
*H10K 59/122* (2023.01)   *H10K 59/40* (2023.01)

(52) Cooperative Patent Classification (CPC):
**H10K 59/122; H10K 59/353; H10K 59/38;
H10K 59/8791; H10K 59/8792**

(86) International application number:
**PCT/KR2024/003578**

(87) International publication number:
**WO 2024/205134 (03.10.2024 Gazette 2024/40)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **24.03.2023 KR 20230039227
21.04.2023 KR 20230052972**

(71) Applicant: **Samsung Display Co., Ltd.
Yongin-si, Gyeonggi-do 17113 (KR)**

(72) Inventors:
• **YOO, Je Won
Yongin-si Gyeonggi-do 17113 (KR)**

• **CHO, Jae Bum
Yongin-si Gyeonggi-do 17113 (KR)**
• **CHOI, Su Jin
Yongin-si Gyeonggi-do 17113 (KR)**
• **KIM, Dae Wook
Yongin-si Gyeonggi-do 17113 (KR)**
• **LEE, Dho Hun
Yongin-si Gyeonggi-do 17113 (KR)**
• **CHO, Hyung Uk
Yongin-si Gyeonggi-do 17113 (KR)**
• **HWANG, Hyun Joo
Yongin-si Gyeonggi-do 17113 (KR)**

(74) Representative: **Gulde & Partner
Patent- und Rechtsanwaltskanzlei mbB
Berliner Freiheit 2
10785 Berlin (DE)**

(54) **DISPLAY DEVICE**

(57)    The present application relates to a display apparatus. The display apparatus includes a substrate, subpixels including first color subpixels including a (1-1)th color subpixel and a (1-2)th color subpixel for emitting light of a same color, light reflected from the (1-1)th color subpixel having a phase difference with respect to light reflected from the (1-2)th color subpixel, second color subpixels, and third color subpixels, each of the subpixels including a subpixel electrode, an emission layer over the subpixel electrode, and an opposite electrode over the emission layer, a bank layer defining lower opening portions defining an emission area in each of the subpixels, a light-blocking layer above the bank layer, and defining upper opening portions respectively overlapping the lower opening portions, and color filters above the light-blocking layer, and including first color filters, second color filters, and third color filters.

FIG. 6

## Description

### Technical Field

One or more embodiments relate to display apparatuses.

### Background Art

Display apparatuses may visually display data. A display apparatus may be used as a display unit of a small product, such as a mobile phone, or as a display unit of a large product, such as a television.

A display apparatus may include a plurality of subpixels that receive an electrical signal to emit light to display an image to the outside. Each subpixel may include a light-emitting device, which may be, for example, an organic light-emitting diode (OLED) in the case of an organic light-emitting display apparatus. Generally, in an organic light-emitting display apparatus, thin film transistors and organic light-emitting diodes are formed over a substrate and the organic light-emitting diodes emit light and operate by themselves.

Recently, as the use of display apparatuses has diversified, various designs have been attempted to improve the quality of display apparatuses.

### Disclosure of Invention

### Technical Problem

One or more embodiments include a high-resolution display apparatus having excellent display quality and improved interference patterns due to reflection and diffraction of external light. However, these problems are merely examples, and the scope of the disclosure is not limited thereto.

### Solution to Problem

According to one or more embodiments, a display apparatus includes a substrate, subpixels including first color subpixels including a (1-1)th color subpixel and a (1-2)th color subpixel for emitting light of a same color, light reflected from the (1-1)th color subpixel having a phase difference with respect to light reflected from the (1-2)th color subpixel, second color subpixels, and third color subpixels, each of the subpixels including a subpixel electrode, an emission layer over the subpixel electrode, and an opposite electrode over the emission layer, a bank layer defining lower opening portions defining an emission area in each of the subpixels, a light-blocking layer above the bank layer, and defining upper opening portions respectively overlapping the lower opening portions, and color filters above the light-blocking layer, and including first color filters, second color filters, and third color filters.

According to one or more embodiments, a display apparatus includes a substrate, subpixels including first color subpixels including a (1-1)th color subpixel and a (1-2)th color subpixel for emitting light of a same color, second color subpixels, and third color subpixels, each of the subpixels including a subpixel electrode, an emission layer over the subpixel electrode, and an opposite electrode over the emission layer, a bank layer defining lower opening portions defining an emission area of each of the subpixels, a light-blocking layer above the bank layer, and defining upper opening portions respectively overlapping the lower opening portions, color filters above the light-blocking layer, and including first color filters, second color filters, and third color filters, and a phase difference pattern layer above the bank layer, and including pattern portions respectively corresponding to the subpixels, the pattern portions including a (1-1)th color pattern portion corresponding to the (1-1)th color subpixel, and a (1-2)th color pattern portion corresponding to the (1-2)th color subpixel and different from the (1-1)th color pattern portion with respect to at least one of refractive index or thickness.

### Advantageous Effects of Invention

According to the above embodiments, a high-resolution display apparatus having an excellent display quality in a display state (on-state) while being improved in the interference pattern due to reflection and diffraction of external light in a non-display state (off-state) is provided. However, the scope of the disclosure is not limited to these effects.

### Brief Description of Drawings

The above and other aspects of embodiments of the disclosure will be more apparent from the following description taken in conjunction with the accompanying drawings.

FIG. 1 is a perspective view schematically illustrating a display apparatus according to one or more embodiments.

FIG. 2 is a circuit diagram illustrating a light-emitting diode included in a subpixel of a display apparatus according to one or more embodiments and a subpixel circuit connected thereto.

FIG. 3 is a cross-sectional view taken along the line A-A' of FIG. 1 and schematically illustrating the display apparatus according to one or more embodiments.

FIG. 4 is a cross-sectional view schematically illustrating a display apparatus according to one or more embodiments.

FIG. 5 is a plan view illustrating an arrangement of subpixels of a portion of a display apparatus according to one or more embodiments.

FIG. 6 is a cross-sectional view schematically illustrating a display apparatus according to one or more embodiments.

FIG. 7 is a cross-sectional view schematically illustrating a display apparatus according to one or more other embodiments.

FIG. 8 is a cross-sectional view schematically illustrating a display apparatus according to one or more other embodiments.

FIG. 9 is a cross-sectional view schematically illustrating a display apparatus according to one or more other embodiments.

FIG. 10 is a plan view illustrating a portion of a display apparatus according to one or more embodiments.

## Best Mode for Carrying out the Invention

The second color subpixels may include a (2-1)th color subpixel and a (2-2)th color subpixel for emitting light of a same color, wherein light reflected from the (2-1)th color subpixel has a phase difference with respect to light reflected from the (2-2)th color subpixel.

The third color subpixels may include a (3-1)th color subpixel and a (3-2)th color subpixel for emitting light of a same color, wherein light reflected from the (3-1)th color subpixel has a phase difference with respect to light reflected from the (3-2)th color subpixel.

The light reflected from the (1-1)th color subpixel and the light reflected from the (1-2)th color subpixel may have a same wavelength in a vacuum.

The light reflected from the (1-1)th color subpixel and the light reflected from the (1-2)th color subpixel may have a phase difference therebetween greater than about 0 and less than about $2\pi$.

A vertical distance from the substrate to the subpixel electrode of the (1-1)th color subpixel may be different from a vertical distance from the substrate to the subpixel electrode of the (1-2)th color subpixel.

A vertical distance from the substrate to the subpixel electrode of the (2-1)th color subpixel may be different from a vertical distance from the substrate to the subpixel electrode of the (2-2)th color subpixel.

A vertical distance from the substrate to the subpixel electrode of the (3-1)th color subpixel may be different from a vertical distance from the substrate to the subpixel electrode of the (3-2)th color subpixel.

The (1-1)th color subpixel and the (1-2)th color subpixel may be adjacent to each other, wherein the (2-1)th color subpixel and the (2-2)th color subpixel are adjacent to each other, and wherein the (3-1)th color subpixel and the (3-2)th color subpixel are adjacent to each other.

The display apparatus may further include a phase difference pattern layer above the bank layer, and including pattern portions respectively corresponding to the subpixels, wherein the pattern portions include a (1-1)th color pattern portion corresponding to the (1-1)th color subpixel, and a (1-2)th color pattern portion corresponding to the (1-2)th color subpixel and different from the (1-1)th color pattern portion with respect to at least one of refractive index or thickness.

The (1-1)th color pattern portion and the (1-2)th color pattern portion may respectively include different materials with different refractive indexes.

The (1-1)th color pattern portion and the (1-2)th color pattern portion may include a same material, wherein a thickness of the (1-1)th color pattern portion is different from a thickness of the (1-2)th color pattern portion.

The (1-1)th color pattern portion and the (1-2)th color pattern portion may respectively include different materials with different refractive indexes, wherein a thickness of the (1-1)th color pattern portion is different from a thickness of the (1-2)th color pattern portion.

The second color subpixels may include a (2-1)th color subpixel and a (2-2)th color subpixel for emitting light of a same color, wherein light reflected from the (2-1)th color subpixel has a phase difference with respect to light reflected from the (2-2)th color subpixel, and wherein the pattern portions further include a (2-1)th color pattern portion corresponding to the (2-1)th color subpixel, and a (2-2)th color pattern portion corresponding to the (2-2)th color subpixel and different from the (2-1)th color pattern portion with respect to at least one of refractive index or thickness.

The third color subpixels may include a (3-1)th color subpixel and a (3-2)th color subpixel for emitting light of a same color, wherein light reflected from the (3-1)th color subpixel has a phase difference with respect to light reflected from the (3-2)th color subpixel, and wherein the pattern portions further include a (3-1)th color pattern portion corresponding to the (3-1)th color subpixel and a (3-2)th color pattern portion corresponding to the (3-2)th color subpixel and different from the (3-1)th color pattern portion with respect to at least one of refractive index or thickness.

Each of the pattern portions may have a width that is greater than a width of a corresponding subpixel among the subpixels.

The pattern portions may include an organic insulating material or an inorganic insulating material.

The display apparatus may further include an encapsulation layer over the subpixels and the bank layer, and a touch sensor layer over the encapsulation layer, wherein the phase difference pattern layer is between the encapsulation layer and the touch sensor layer.

The display apparatus may further include a cover window over the color filters, wherein the phase difference pattern layer is between the subpixels and the cover window.

## Mode for the Invention

The present disclosure may be embodied in different forms, and may have various modifications. Specific embodiments are illustrated in the drawings and described in detail in the detailed description. The effects and features of the present disclosure, and methods of achieving them, will become apparent by reference to the embodiments described in detail below in conjunction with the accompanying drawings. However, the present disclosure is not limited to the disclosed embodiments but may be implemented in various forms.

As used herein, the expression such as "A and/or B" may include A, B, or A and B. Similarly, the expression such as "at least one of A and B" may include A, B, or A and B.

In the following embodiments, terms such as "first" and "second" are used only to distinguish one component from another and are not limited by these terms.

In the following embodiments, the singular forms are also intended to include the plural forms unless the context clearly indicates otherwise.

In the following embodiments, the meaning of a line "extending in a first direction or a second direction" may include not only extending in a linear shape but also extending in a zigzag or curved shape in the first direction or the second direction, or any combination thereof.

In the following embodiments, the terms such as "comprise," "have," and the like are intended to specify the presence of stated features or components, and do not preclude the presence or addition of one or more other features or components.

In the following embodiments, when a film, region, or component is described as being on or over another part, it may mean not only that it is directly on the other part, but also that one or more other films, regions, or components may be interposed in between.

In the drawings, the size of components may be exaggerated or reduced for convenience of explanation. For example, the sizes and thicknesses of each component shown in the drawings may be illustrated arbitrarily for descriptive convenience, and the present disclosure is not necessarily limited to the illustrated configurations.

In cases where a specific process order may be implemented differently, the particular process sequence described may be performed in a different order. For example, two processes described consecutively may actually be performed simultaneously, or in a reverse order than described.

In the following embodiments, when a film, region, or component is described as being connected to another film, region, or component, it includes not only directly connected cases but also indirectly connected cases where other films, regions, or components are interposed in between. For example, when a film, region, or component is referred to as being "electrically connected" to another film, region, or component, it may be directly electrically connected to the other film, region, or component or intervening films, regions, or components may be present.

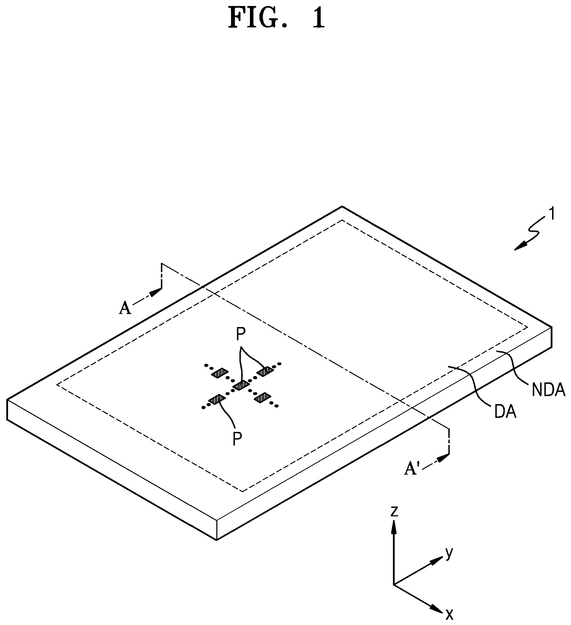

FIG. 1 is a perspective view schematically illustrating a display apparatus according to one or more embodiments.

Referring to FIG. 1, a display apparatus 1 may include a display area DA, and a peripheral area NDA outside the display area DA. The display apparatus 1 may provide an image through an array of a plurality of subpixels P two-dimensionally arranged in the display area DA.

Each subpixel P of the display apparatus 1 may be an area capable of emitting light of a corresponding color, and the display apparatus 1 may provide an image by using light emitted from the subpixels P. For example, each subpixel P may emit red, green, blue, or white light.

Each of the subpixels P may emit light of a corresponding color by using a light-emitting diode, for example, an organic light-emitting diode. Each organic light-emitting diode may emit, for example, red, green, blue, or white light. Each organic light-emitting diode may be connected to a subpixel circuit including a thin film transistor and a capacitor.

The peripheral area NDA may be an area not providing an image, and may entirely surround the display area DA (e.g., in plan view). A driver or a main power line for providing an electrical signal or power to subpixel circuits may be arranged in the peripheral area NDA. The peripheral area NDA may include a pad that is an area to which an electronic device or a printed circuit board may be electrically connected.

The display area DA may have a polygonal shape, such as a tetragonal shape as illustrated in FIG. 1. For example, the display area DA may have a rectangular shape in which the horizontal length is greater than the vertical length, a rectangular shape in which the horizontal length is less than the vertical length, or a square shape. Alternatively, the display area DA may have various shapes, such as an elliptical shape or a circular shape.

The display apparatus 1 may include a mobile phone, a television, a billboard, a tablet personal computer, a notebook, a smart band, or a smart watch worn on the wrist.

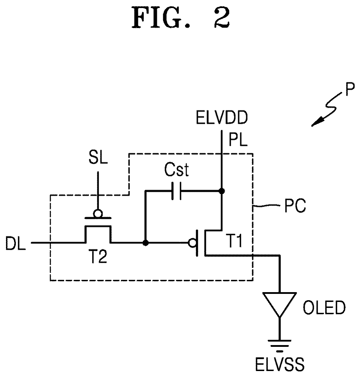

FIG. 2 is a circuit diagram illustrating a light-emitting diode included in a subpixel of a display apparatus according to one or more embodiments and a subpixel circuit PC connected thereto.

Referring to FIG. 2, a light-emitting diode, such as an organic light-emitting diode OLED may be connected to a subpixel circuit PC. The subpixel circuit PC may include a first thin film transistor T1, a second thin film transistor T2, and a storage capacitor Cst.

As a switching thin film transistor, the second thin film transistor T2 may be connected to a scan line SL and a data line DL, and may be configured to transmit a data voltage input from the data line DL to the first thin film transistor T1 according to a switching voltage input from the scan line SL. The storage capacitor Cst may be connected to the second thin film transistor T2 and a driving voltage line PL, and may be configured to store a voltage corresponding to the difference between a voltage received from the second thin film transistor T2 and a driving voltage ELVDD supplied to the driving voltage line PL.

As a driving thin film transistor, the first thin film transistor T1 may be connected to the driving voltage line PL, and the storage capacitor Cst and may be configured to control a driving current flowing from the driving voltage line PL through the organic light-emitting diode OLED in response to a voltage value stored in the storage capacitor Cst. The organic light-emitting diode OLED may emit light with a corresponding brightness according to the driving current. A subpixel electrode (e.g., anode) of the organic light-emitting diode OLED may be connected to the subpixel circuit PC, and an opposite electrode (e.g., cathode) of the organic light-emitting diode OLED may receive a common voltage ELVSS.

FIG. 2 illustrates that the subpixel circuit includes two thin film transistors and one storage capacitor. However, in other embodiments, the number of thin film transistors or the number of storage capacitors may be variously modified according to the design of the subpixel circuit PC.

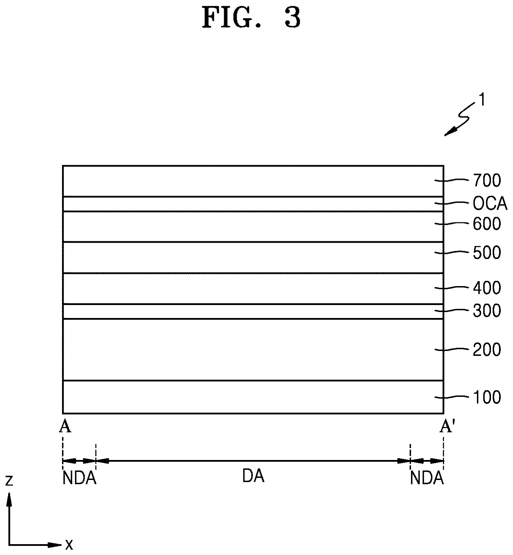

FIG. 3 is a cross-sectional view taken along the line A-A' of FIG. 1 and schematically illustrating the display apparatus 1 according to embodiments.

Referring to FIG. 3, the display apparatus 1 may include a substrate 100, a display layer 200, a low-reflection layer 300, an encapsulation layer 400, a touch sensor layer 500, an anti-reflection layer 600, an adhesive layer OCA, and a cover window 700.

The substrate 100 may include glass or polymer resin. For example, the polymer resin may include polyether sulfone, polyacrylate, polyether imide, polyethylene naphthalate, polyethylene terephthalate, polyphenylene sulfide, polyarylate, polyimide, polycarbonate, or cellulose acetate propionate. The substrate 100 including the polymer resin may be flexible, rollable, or bendable. The substrate 100 may have a multilayer structure including an inorganic layer and a layer including the polymer resin.

The display layer 200 may include a light-emitting diode, for example, an organic light-emitting diode, a thin film transistor electrically connected thereto, and insulating layers arranged between the components of the thin film transistor.

The low-reflection layer 300 may be located over the display layer 200, and the encapsulation layer 400 may be located over the low-reflection layer 300. For example, the display layer 200 and/or the low-reflection layer 300 may be encapsulated by the encapsulation layer 400. In some embodiments, the low-reflection layer 300 may be omitted. In this case, the encapsulation layer 400 may be directly located over the display layer 200. The encapsulation layer 400 may include at least one inorganic encapsulation layer and at least one organic encapsulation layer.

In some embodiments, an encapsulation substrate including a glass material may be provided, instead of the encapsulation layer 400. The encapsulation substrate may be located over the display layer 200, and the display layer 200 may be arranged between the substrate 100 and the encapsulation substrate. There may be a gap between the encapsulation substrate and the display layer 200, and the gap may be filled with a filler.

The touch sensor layer 500 may be located over the encapsulation layer 400. The touch sensor layer 500 may be configured to sense an external input, for example, a touch of an object, such as a finger or a stylus pen, such that the display apparatus 1 may obtain coordinate information corresponding to a touch position. The touch sensor layer 500 may include a touch electrode and trace lines connected to the touch electrode. The touch sensor layer 500 may be configured to sense an external input by a mutual-cap method or a self-cap method.

The touch sensor layer 500 may be directly formed over the encapsulation layer 400. Alternatively, the touch sensor layer 500 may be separately formed and then adhered onto the encapsulation layer 400 through an adhesive layer, such as optically clear adhesive.

The anti-reflection layer 600 may be located over the touch sensor layer 500. The anti-reflection layer 600 may reduce the reflectance of external light incident from the outside through the cover window 700 toward inside the display apparatus 1.

The anti-reflection layer 600 may include a light-blocking layer and color filters. The color filters may be arranged considering the color of light emitted from each of the light-emitting diodes of the display layer 200.

The cover window 700 may be located over the anti-reflection layer 600. The cover window 700 may protect a display panel. The cover window 700 may be separately formed and then attached to the anti-reflection layer 600 by the adhesive layer OCA arranged between the cover window 700 and the anti-reflection layer 600. The adhesive layer OCA may include, for example, an optically clear adhesive. Alternatively, the cover window 700 may be directly formed over the anti-reflection layer 600.

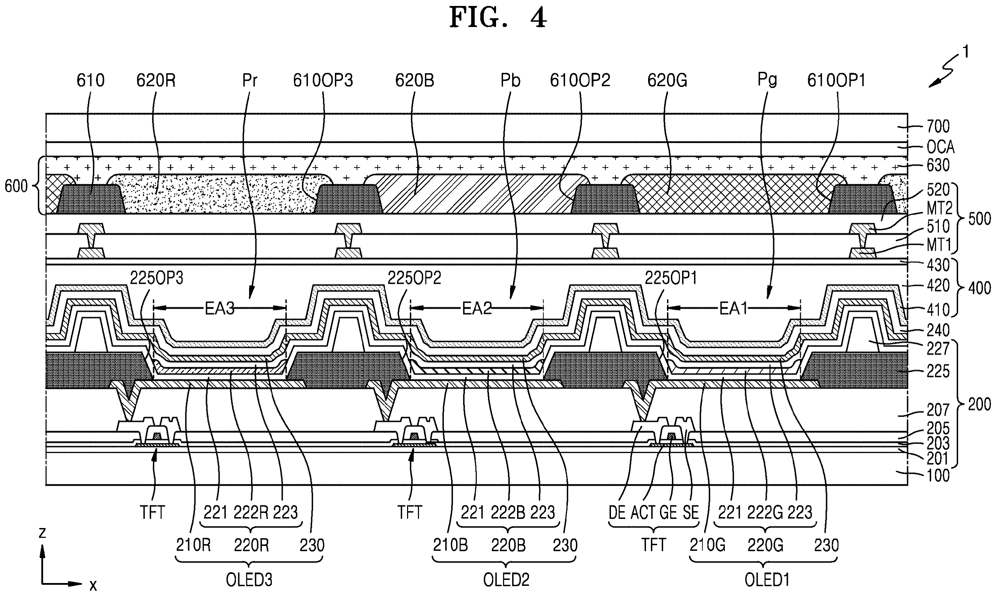

FIG. 4 is a cross-sectional view schematically illustrating a portion of a display apparatus according to one or more embodiments. Hereinafter, a stack structure of the display apparatus 1 will be described in more detail with reference to FIG. 4.

Referring to FIG. 4, the display apparatus 1 may include a substrate 100, a display layer 200, an encapsulation layer 400, a touch sensor layer 500, an anti-reflection layer 600, an adhesive layer (OCA), and a cover window 700.

The display apparatus 1 may include a plurality of subpixels arranged in the display area DA (see FIG. 3). Each of the plurality of subpixels may emit red, green, or blue light. The plurality of subpixels may include subpixels exhibiting different colors, for example, a first color subpixel, a second color subpixel, and a third color subpixel. The first color subpixel may be provided as a plurality of first color subpixels, the second color subpixel may be provided as a plurality of second color subpixels, and the third color subpixel may be provided as a plurality of third color subpixels. In one or more embodiments, the first color subpixel may be a green subpixel Pg capable of emitting green light, the second color subpixel may be a blue subpixel Pb capable of emitting blue light, and the third color subpixel may be a red subpixel Pr capable of emitting red light.

The display layer 200 may be located over the substrate 100. The display layer 200 may include a subpixel circuit layer and a light-emitting diode layer. The subpixel circuit layer may include a thin film transistor TFT and may include a buffer layer 201, a gate-insulating layer 203, an interlayer insulating layer 205, and a planarization layer 207 that are insulating layers.

The buffer layer 201 may be located over the substrate 100 to reduce or block the penetration of foreign materials, moisture, or external air from under the substrate 100 and may provide a flat surface over the substrate 100. The buffer layer 201 may include an inorganic material, such as oxide or nitride, an organic material, or an organic/inorganic composite, and may include a single-layer or multiple-layer structure of an inorganic material and an organic material. A barrier layer for blocking the penetration of external air may be further included between the substrate 100 and the buffer layer 201. For example, the buffer layer 201 may include silicon oxide or silicon nitride.

The thin film transistor TFT may be located over the buffer layer 201. The thin film transistor TFT may include a semiconductor layer ACT, a gate electrode GE, a source electrode SE, and a drain electrode DE. The thin film transistor TFT may be connected to an organic light-emitting diode to drive the organic light-emitting diode.

The semiconductor layer ACT may be located over the buffer layer 201. The semiconductor layer ACT may include polysilicon or amorphous silicon. Alternatively, the semiconductor layer ACT may include an oxide of at least one of indium (In), gallium (Ga), stannum (Sn), zirconium (Zr), vanadium (V), hafnium (Hf), cadmium (Cd), germanium (Ge), chromium (Cr), titanium (Ti), or zinc (Zn). The semiconductor layer ACT may include a channel area, and a source area and a drain area that are doped with dopants.

The gate electrode GE, the source electrode SE, and the drain electrode DE may be formed of various conductive materials. In one or more embodiments, the gate electrode GE may include at least one of molybdenum (Mo), aluminum (Al), copper (Cu), or titanium (Ti). For example, the gate electrode GE may include a single molybdenum (Mo) layer or may include a three-layer structure including a molybdenum (Mo) layer, an aluminum (Al) layer, and a molybdenum (Mo) layer. In one or more embodiments, the source electrode SE and the drain electrode DE may include at least one of copper (Cu), titanium (Ti), or aluminum (Al). For example, the source electrode SE and the drain electrode DE may include a three-layer structure including a titanium (Ti) layer, an aluminum (Al) layer, and a titanium (Ti) layer.

Moreover, to secure the insulation between the semiconductor layer ACT and the gate electrode GE, the gate-insulating layer 203 may be arranged between the semiconductor layer ACT and the gate electrode GE. The interlayer insulating layer 205 may be located over the gate electrode GE, and the source electrode SE and the drain electrode DE may be located over the interlayer insulating layer 205.

Each of the gate-insulating layer 203 and the interlayer insulating layer 205 may include an inorganic material, such as silicon oxide, silicon nitride, and/or silicon oxynitride. The gate-insulating layer 203 and the interlayer insulating layer 205 may be formed through, for example, chemical vapor deposition (CVD) or atomic layer deposition (ALD).

The planarization layer 207 may be located over the thin film transistor TFT. To provide a flat upper surface, chemical mechanical polishing may be performed on the upper surface of the planarization layer 207 after the planarization layer 207 is formed. The planarization layer 207 may include a general-purpose polymer, such as photosensitive polyimide, polyimide, polystyrene (PS), polycarbonate, benzocyclobutene (BCB), hexamethyldisiloxane (HMDSO), or polymethylmethacrylate (PMMA), a polymer derivative having a phenolic group, an acrylic polymer, an imide-based polymer, an aryl ether-based polymer, an amide-based polymer, a fluorine-based polymer, a p-xylene-based polymer, or a vinyl alcohol-based polymer. FIG. 4 illustrates that the planarization layer 207 includes a single layer. However, in some embodiments, the planarization layer 207 may include multiple layers. Each of subpixel electrodes 210G, 210B, and 210R of first to third organic light-emitting diodes OLED1, OLED2, and OLED3 may be electrically connected to the thin film transistor TFT through a contact hole of the planarization layer 207.

The light-emitting diode layer may be located over the subpixel circuit layer. In one or more embodiments, the light-emitting diode layer may include first to third organic light-emitting diodes OLED1, OLED2, and OLED3, a bank layer 225, and a spacer 227.

The first to third organic light-emitting diodes OLED1, OLED2, and OLED3 may be located over the subpixel circuit layer. The first organic light-emitting diode OLED1 may include a stack structure of a subpixel electrode 210G, an intermediate layer 220G including a first common layer 221, an emission layer 222G, and a second common layer 223, and an opposite electrode 230. The second organic light-emitting diode OLED2 may include a subpixel electrode 210B, an intermediate layer 220B including a first common layer 221, an emission layer 222B, and a second common layer 223, and an opposite electrode 230. The third organic light-emitting diode OLED3 may include a subpixel electrode 210R, an intermediate layer 220R including a first common layer 221, an emission layer 222R, and a second common layer 223, and an opposite electrode 230.

The subpixel electrodes 210G, 210B, and 210R may be located over the planarization layer 207. The subpixel electrodes 210G, 210B, and 210R may be arranged apart from each other.

The subpixel electrodes 210G, 210B, and 210R may be reflective electrodes. The subpixel electrodes 210G, 210B, and 210R may include a reflective layer including silver (Ag), magnesium (Mg), aluminum (Al), platinum (Pt), palladium (Pd), gold (Au), nickel (Ni), neodymium (Nd), iridium (Ir), chromium (Cr), or any compound thereof, and a transparent or semitransparent conductive layer formed over the reflective layer. The transparent or semitransparent conductive layer may include at least one of indium tin oxide (ITO), indium zinc oxide (IZO), zinc oxide (ZnO), indium oxide ($in_2O_3$), indium gallium oxide (IGO), or aluminum zinc oxide (AZO).

The bank layer 225 may be located over the subpixel electrodes 210G, 210B, and 210R. The bank layer 225 may include (or define) first to third lower opening portions 225OP1, 225OP2, and 225OP3 respectively overlapping the subpixel electrodes 210G, 210B, and 210R, and respectively exposing center portions of the subpixel electrodes 210G, 210B, and 210R. The bank layer 225 may cover the edge of the subpixel electrodes 210G, 210B, and 210R, and may increase the distance between the edge of the subpixel electrodes 210G, 210B, and 210R and the opposite electrode 230 to reduce or prevent the likelihood of an arc or the like from occurring at the edge of the subpixel electrodes 210G, 210B, and 210R.

The first to third lower opening portions 225OP1, 225OP2, and 225OP3 of the bank layer 225 may define first to third emission areas EA1, EA2, and EA3 of the first to third organic light-emitting diodes OLED1, OLED2, and OLED3 included in the respective subpixels. As illustrated in FIG. 4, the bank layer 225 may include the first lower opening portion 225OP1 defining the first emission area EA1 of the first organic light-emitting diode OLED1 of the first color subpixel. Also, the bank layer 225 may include the second lower opening portion 225OP2 defining the second emission area EA2 of the second organic light-emitting diode OLED2 of the second color subpixel. Additionally, the bank layer 225 may include the third lower opening portion 225OP3 defining the third emission area EA3 of the third organic light-emitting diode OLED3 of the third color subpixel.

The bank layer 225 may include an organic insulating material. Alternatively, the bank layer 225 may include an inorganic insulating material, such as silicon nitride or silicon oxide. In some embodiments, the bank layer 225 may include an organic insulating material and an inorganic insulating material.

In one or more embodiments, the bank layer 225 may include a light-blocking material. For example, the light-blocking material of the bank layer 225 may be black. The light-blocking material may include a resin or paste including carbon black, carbon nanotube, or black dye, metal particles (e.g., nickel, aluminum, molybdenum, or any alloy thereof), metal oxide particles, or metal nitride particles. When the bank layer 225 includes a light-blocking material, the reflection of external light by metal structures located under the bank layer 225 may be reduced.

The spacer 227 may be located over the bank layer 225. The spacer 227 may include an organic insulating material, such as polyimide. Alternatively, the spacer 227 may include an inorganic insulating material, such as silicon nitride or silicon oxide or may include an organic insulating material and an inorganic insulating material. In one or more embodiments, the spacer 227 may include a different material than the bank layer 225 including the above light-blocking material and may be formed in a separate process from the bank layer 225.

In one or more other embodiments, the spacer 227 may include the same material as the bank layer 225. In this case, the bank layer 225 and the spacer 227 may be formed together in a mask process using a halftone mask.

An intermediate layer may be located over the subpixel electrodes 210G, 210B, and 210R and the bank layer 225. As described above, the intermediate layer may include a first common layer 221, an emission layer, and a second common layer 223.

The emission layers 222G, 222B, and 222R may be respectively arranged inside the first to third lower opening portions 225OP1, 225OP2, and 225OP3 of the bank layer 225. The emission layers 222G, 222B, and 222R may include an organic material including a fluorescent or phosphorescent material capable of emitting blue, green, or red light. The above organic material layer may include a low-molecular weight organic material or a high-molecular weight organic material.

The first common layer 221 and the second common layer 223 may be respectively located under and over the emission layers 222G, 222B, and 222R. The first common layer 221 may include, for example, a hole transport layer (HTL) or may include an HTL and a hole injection layer (HIL). The second common layer 223 may include, for example, an electron transport layer (ETL) or may include an ETL and an electron injection layer (EIL). In one or more embodiments, the second common layer 223 may be omitted.

The emission layer 222G, 222B, or 222R may be arranged in each subpixel to correspond to the first to third lower opening portions 225OP1, 225OP2, and 225OP3 of the bank layer 225, whereas each of the first common layer 221 and the second common layer 223 may be integrally formed to entirely cover the substrate 100. In other words, each of the first common layer 221 and the second common layer 223 may be integrally formed to entirely cover the display area DA of the substrate 100.

The opposite electrode 230 may be a cathode, that is, an electron injection electrode. The opposite electrode 230 may include a conductive material having a low work function. For example, the opposite electrode 230 may include a (semi)transparent layer including silver (Ag), magnesium (Mg), aluminum (Al), platinum (Pt), palladium (Pd), gold (Au), nickel (Ni), neodymium (Nd), iridium (Ir), chromium (Cr), lithium (Li), calcium (Ca), or any alloy thereof. Alternatively, the opposite electrode 230 may further include a layer, such as ITO, IZO, ZnO, or $In_2O_3$ over the (semi)transparent layer including the above material.

In one or more embodiments, a capping layer 240 may be further located over the display layer 200. The capping layer 240 may be located over the first to third organic light-emitting diodes OLED1, OLED2, and OLED3. In one or more embodiments, the capping layer 240 may improve the light emission efficiency of the first to third organic light-emitting diodes OLED1, OLED2, and OLED3 due to constructive interference.

The capping layer 240 may be an organic capping layer including an organic material, an inorganic capping layer including an inorganic material, or a composite capping layer including an organic material and an inorganic material. For example, the capping layer 240 may include a carbocyclic compound, a heterocyclic compound, an amine group-containing compound, a porphine derivative, a phthalocyanine derivative, a naphthalocyanine derivative, an alkali metal complex, an alkaline earth metal complex, or any combination thereof. The carbocyclic compound, the heterocyclic compound, and the amine group-containing compound may be selectively substituted with a substituent including O, N, S, Se, Si, F, Cl, Br, I, or any combination thereof.

The encapsulation layer 400 may be located over the capping layer 240. The encapsulation layer 400 may include at least one inorganic encapsulation layer and at least one organic encapsulation layer. For example, as illustrated in FIG. 4, the encapsulation layer 400 may include a first inorganic encapsulation layer 410, an organic encapsulation layer 420, and a second inorganic encapsulation layer 430 that are sequentially stacked.

The first inorganic encapsulation layer 410 and the second inorganic encapsulation layer 430 may include an inorganic insulating material, such as silicon oxide, silicon nitride, silicon oxynitride, aluminum oxide, titanium oxide, tantalum oxide, hafnium oxide, or zinc oxide. The first inorganic encapsulation layer 410 and the second inorganic encapsulation layer 430 may have a single-layer or multiple-layer structure including the above inorganic insulating material.

The organic encapsulation layer 420 may relieve the internal stress of the first inorganic encapsulation layer 410 and/or the second inorganic encapsulation layer 430. The organic encapsulation layer 420 may include a polymer-based material. For example, the organic encapsulation layer 420 may include polyethyleneterephthalate, polyethylenenaphthalate, polycarbonate, polyimide, polyethylenesulfonate, polyoxymethylene, polyarylate, hexamethyldisiloxane, acrylic resin (e.g., polymethylmethacrylate or polyacrylic acid), or any combination thereof.

The encapsulation layer 400 may have a multilayer structure of the first inorganic encapsulation layer 410, the organic encapsulation layer 420, and the second inorganic encapsulation layer 430. In this case, even when a crack occurs in the encapsulation layer 400, the crack may not propagate between the first inorganic encapsulation layer 410 and the organic encapsulation layer 420 or between the organic encapsulation layer 420 and the second inorganic encapsulation layer 430. The encapsulation layer 400 may prevent, reduce, or minimize the penetration of external moisture or oxygen into the display area DA.

The touch sensor layer 500 may be located over the encapsulation layer 400. The touch sensor layer 500 may include a first touch electrode MT1, a first touch insulating layer 510, a second touch electrode MT2, and a second touch insulating layer 520. The first touch electrode MT1 may be directly located over the encapsulation layer 400. For example, the first touch electrode MT1 may be directly located over the second inorganic encapsulation layer 430 of the encapsulation layer 400. However, the disclosure is not limited thereto.

In one or more embodiments, the touch sensor layer 500 may include an insulating layer arranged between the first touch electrode MT1 and the encapsulation layer 400. In this case, the insulating layer may be located over the second inorganic encapsulation layer 430 of the encapsulation layer 400 to planarize a surface on which the first touch electrode MT1 and the like are arranged. The insulating layer may include an inorganic insulating material, such as silicon oxide, silicon nitride, or silicon oxynitride. In some embodiments, the insulating layer may include an organic insulating material.

The first touch insulating layer 510 may be located over the first touch electrode MT1. The first touch insulating layer 510 may include an inorganic material or an organic material. When the first touch insulating layer 510 includes an inorganic material, the first touch insulating layer 510 may include at least one of silicon nitride, aluminum nitride, zirconium nitride, titanium nitride, hafnium nitride, tantalum nitride, silicon oxide, aluminum oxide, titanium oxide, tin oxide, cerium oxide, or silicon oxynitride. When the first touch insulating layer 510 includes an organic material, the first touch insulating layer 510 may include at least one of acryl-based resin, methacryl-based resin, polyisoprene, vinyl-based resin, epoxy-based resin, urethane-based resin, cellulose-based resin, or perylene-based resin.

The second touch electrode MT2 may be located over the first touch insulating layer 510. The second touch electrode MT2 may function as a sensor for sensing a user's touch input. The first touch electrode MT1 may function as a connector for connecting the second touch electrode MT2 patterned, in one direction. In one or more embodiments, both the first touch electrode MT1 and the second touch electrode MT2 may function as a sensor. In this case, the first touch electrode MT1 and the second touch electrode MT2 may be electrically connected through a contact hole. When both the first touch electrode MT1 and the second touch electrode MT2 function as a sensor, the resistance of the touch electrodes may decrease, and thus a user's touch input may be rapidly sensed.

In one or more embodiments, the first touch electrode MT1 and the second touch electrode MT2 may have a structure through which light emitted from the organic light-emitting diodes OLED1, OLED2, and OLED3 may pass, for example, a mesh structure. In this case, the first touch electrode MT1 and the second touch electrode MT2 may be arranged not to overlap the emission areas EA1, EA2 and EA3 of the organic light-emitting diodes OLED1, OLED2, and OLED3.

The first touch electrode MT1 and the second touch electrode MT2 may include a metal layer or a transparent conductive layer. The metal layer may include molybdenum (Mo), silver (Ag), titanium (Ti), copper (Cu), aluminum (Al), or any alloy thereof. The transparent conductive layer may include a transparent conductive oxide, such as indium tin oxide (ITO), indium zinc oxide (IZO), zinc oxide (ZnO), or indium tin zinc oxide (ITZO), a conductive polymer, such as PEDOT, a metal nanowire, a carbon nanotube, or graphene.

The second touch insulating layer 520 may be located over the second touch electrode MT2. The second touch insulating layer 520 may include an inorganic material or an organic material. When the second touch insulating layer 520 includes an inorganic material, the second touch insulating layer 520 may include at least one of silicon nitride, aluminum nitride, zirconium nitride, titanium nitride, hafnium nitride, tantalum nitride, silicon oxide, aluminum oxide, titanium oxide, tin oxide, cerium oxide, or silicon oxynitride. When the second touch insulating layer 520 includes an organic material, the second touch insulating layer 520 may include at least one of acryl-based resin, methacryl-based resin, polyisoprene, vinyl-based resin, epoxy-based resin, urethane-based resin, cellulose-based resin, or perylene-based resin.

In some embodiments, the touch sensor layer 500 may include the first touch electrode MT1, the first touch insulating layer 510, and the second touch electrode MT2 and may not include the second touch insulating layer 520. In this case, the anti-reflection layer 600 may be provided to cover the second touch electrode MT2.

The anti-reflection layer 600 may be located over the touch sensor layer 500. The anti-reflection layer 600 may include a light-blocking layer 610 and a plurality of color filters. In one or more embodiments, the anti-reflection layer 600 may include first to third color filters 620G, 620B, and 620R of different respective colors, which respectively correspond to the first to third organic light-emitting diodes OLED1, OLED2, and OLED3. Each of the first to third color filters 620G, 620B, and 620R may be provided as a plurality of color filters.

The light-blocking layer 610 may include (or define) first to third upper opening portions 610OP1, 610OP2, and 610OP3 respectively corresponding to the first to third color subpixels. The light-blocking layer 610 may include the first upper opening portion 610OP1 corresponding to the first emission area EA1, the second upper opening portion 610OP2 corresponding to the second emission area EA2, and the third upper opening portion 610OP3 corresponding to the third emission area EA3. Light emitted from the first to third organic light-emitting diodes OLED1, OLED2, and OLED3 may be emitted to the outside through the first to third upper opening portions 610OP1, 610OP2, and 610OP3 of the light-blocking layer 610.

The first upper opening portion 610OP1 of the light-blocking layer 610 may overlap the first lower opening portion 225OP1 of the bank layer 225, the second upper opening portion 610OP2 may overlap the second lower opening portion 225OP2, and the third upper opening portion 610OP3 may overlap the third lower opening portion 225OP3.

Herein, the width (or size) of each subpixel may refer to the width (or size) of the emission area of the organic light-emitting diode implementing each subpixel, and the width (or size) of the emission area may be defined by the width (or size) of the lower opening portion included in the bank layer 225.

In one or more embodiments, the width (or size) of each of the first to third upper opening portions 610OP1, 610OP2, and 610OP3 of the light-blocking layer 610 may be greater than the width (or size) of a corresponding subpixel among the first to third color subpixels. That is, the width (or size) of the first to third upper opening portions 610OP1, 610OP2, and 610OP3 of the light-blocking layer 610 may be greater than (e.g., may be respectively greater than) the size (or width) of the first to third lower opening portions 225OP1, 225OP2, and 225OP3 of the bank layer 225 corresponding thereto.

In one or more other embodiments, the width (or size) of each of the first to third upper opening portions 610OP1, 610OP2, and 610OP3 of the light-blocking layer 610 may be substantially equal to the width (or size) of a corresponding subpixel among the first to third color subpixels. That is, the width (or size) of the first to third upper opening portions 610OP1, 610OP2, and 610OP3 of the light-blocking layer 610 may be substantially equal to (e.g., may be respectively substantially equal to) the width (or size) of the first to third lower opening portions 225OP1, 225OP2, and 225OP3 of the bank layer 225 corresponding thereto.

The light-blocking layer 610 may include an organic insulating material. Alternatively, the light-blocking layer 610 may include an inorganic insulating material, such as silicon nitride or silicon oxide. In some embodiments, the light-blocking layer 610 may include an organic insulating material and an inorganic insulating material.

In one or more embodiments, the light-blocking layer 610 may include a light-blocking material. For example, the light-blocking material of the light-blocking layer 610 may be black. The light-blocking material may include a resin or paste including carbon black, carbon nanotube, or black dye, metal particles (e.g., nickel, aluminum, molybdenum, or any alloy thereof), metal oxide particles, or metal nitride particles. Because the light-blocking layer 610 includes a light-blocking material, the reflection of external light by metal structures located thereunder may be reduced.

The first to third color filters 620G, 620B, and 620R may be respectively arranged in the first to third upper opening portions 610OP1, 610OP2, and 610OP3 of the light-blocking layer 610. The first to third color filters 620G, 620B, and 620R may have a color corresponding to the light emitted from the first to third emission areas EA1, EA2, and EA3. In one or more embodiments, the first color filter 620G may be a green color filter when the first emission area EA1 emits green light, the second color filter 620B may be a blue color filter when the second emission area EA2 emits blue light, and the third color filter 620R may be a red color filter when the third emission area EA3 emits red light.

The anti-reflection layer 600 may further include an overcoat layer 630. The overcoat layer 630 may be located over the light-blocking layer 610 and the first to third color filters 620G, 620B, and 620R. The overcoat layer 630 may planarize the upper surfaces of the light-blocking layer 610 and the first to third color filters 620G, 620B, and 620R. The overcoat layer 630 may be a colorless transparent layer having no visible light band color. The overcoat layer 630 may include a colorless transparent organic material, such as an acryl-based resin.

The cover window 700 may be located over the overcoat layer 630 with the adhesive layer OCA therebetween.

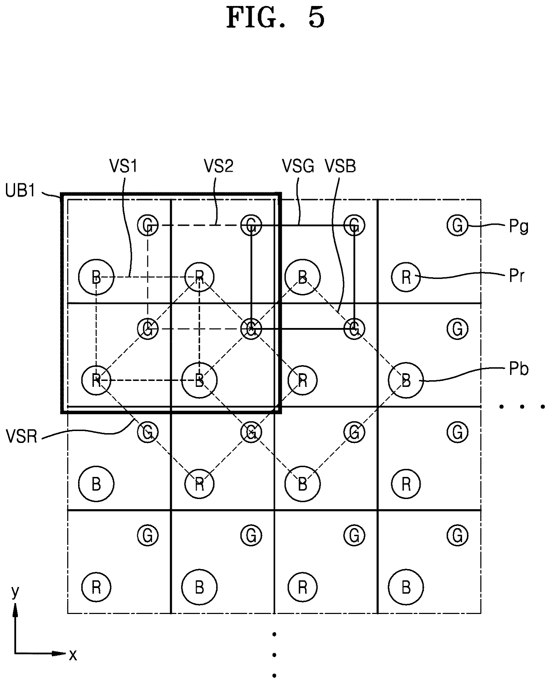

FIG. 5 is a plan view illustrating an arrangement of subpixels of a portion of a display apparatus according to one or more embodiments.

Referring to FIG. 5, a plurality of subpixels of the display apparatus may include a first color subpixel, a second color subpixel, and a third color subpixel. In one or more embodiments, the first color subpixel may be a green subpixel Pg, the second color subpixel may be a blue subpixel Pb, and the third color subpixel may be a red subpixel Pr. Hereinafter, it is assumed that the first color subpixel is a green subpixel Pg, the second color subpixel is a blue subpixel Pb, and the third color subpixel is a red subpixel Pr.

The red subpixel Pr, the blue subpixel Pb, and the green subpixel Pg may have a repeated arrangement structure. Red subpixels Pr and blue subpixels Pb may be arranged at the vertexes of a virtual square VS1 having a green subpixel Pg as a center point. The red subpixels Pr may be arranged at opposite vertexes with the green subpixel Pg therebetween in the diagonal direction of the virtual square VS1, and the blue subpixels Pb may be arranged at different opposite vertexes with the green subpixel Pg therebetween in the diagonal direction of the virtual square VS1. Also, green subpixels Pg may be respectively located at the vertexes of a virtual square VS2 having a subpixel (a blue subpixel Pb or a red subpixel Pr) located at a vertex of the virtual square VS1 as a center point thereof. In this case, the virtual squares VS1 and VS2 may be variously modified into a rectangle, a rhombus, a square, or the like.

In other words, as for the subpixel arrangement of FIG. 5, the red subpixel Pr, the blue subpixel Pb, and the green subpixel Pg may be arranged in a PENTILE™ structure (e.g., a RGBG matrix structure, a PENTILE™ matrix structure, or an RGBG structure, PENTILE™ being a registered trademark of Samsung Display Co., Ltd., Republic of Korea), for example, a diamond pentile structure. However, the disclosure is not limited thereto. For example, the red subpixel Pr, the blue subpixel Pb, and the green subpixel Pg may be arranged in a stripe structure. Also, in some embodiments, the red subpixel Pr, the blue subpixel Pb, and the green subpixel Pg may be arranged in various subpixel arrangement structures, such as a mosaic structure and a delta structure.

The red subpixel Pr, the blue subpixel Pb, and the green subpixel Pg may have a circular shape. However, the disclosure is not limited thereto. In some embodiments, the red subpixel Pr, the blue subpixel Pb, and the green subpixel Pg may have an elliptical shape or a polygonal shape. The polygonal shape may include a shape in which vertexes are rounded.

The sizes (or widths) of the red subpixel Pr, the blue subpixel Pb, and the green subpixel Pg may be different from each other. For example, the size (or width) of the green subpixel Pg may be less than the sizes (or widths) of the red subpixel Pr and the blue subpixel Pb. The size (or width) of the blue subpixel Pb may be greater than the size (or width) of the red subpixel Pr. In other embodiments, the sizes of the red subpixel Pr, the blue subpixel Pb, and the green subpixel Pg may be substantially equal to each other, and various modifications may be made therein.

The subpixels of the display apparatus may include a repeated arrangement structure of a corresponding subpixel pattern unit block UB1. For example, an arrangement of red subpixels Pr, blue subpixels Pb, and green subpixels Pg may correspond to a repeated arrangement of a corresponding subpixel pattern unit block UB1. The subpixel pattern unit block UB1 may be a virtual unit block having a corresponding area including a red subpixel Pr, a blue subpixel Pb, and a green subpixel Pg, and may be understood as corresponding to a minimum repetition unit of the arrangement pattern of the subpixels included in the display apparatus. In one or more embodiments, the subpixel pattern unit block UB1 may have a rectangular shape. For example, the subpixel pattern unit block UB1 may have a square shape.

The subpixel pattern unit block UB1 may include red subpixels Pr, blue subpixels Pb, and green subpixels Pg, wherein the sum of the number of red subpixels Pr and the number of blue subpixels Pb included in the subpixel pattern unit block UB1 may be equal to the number of green subpixels Pg included therein. FIG. 5 illustrates the subpixel pattern unit block UB1 including two red subpixels Pr, two blue subpixels Pb, and four green subpixels Pg.

Referring to FIG. 4, the display apparatus 1 of the disclosure may include the anti-reflection layer 600 including the light-blocking layer 610 and the first to third color filters 620G, 620B, and 620R. In this case, compared to a case where the anti-reflection layer 600 includes a polarization film arranged on the front surface of the substrate 100, the light efficiency may be suitable, but the light reflected and output by each subpixel (e.g., the subpixel electrode or opposite electrode of each subpixel) may increase relatively. Thus, an interference pattern due to the diffraction of lights reflected from the subpixels of the display apparatus 1 may increase. The interference pattern may be viewed in a non-display state (off-state) of the display apparatus 1, and when the interference pattern increases, a double image may become prominent, and the quality of the display apparatus 1 in the non-display state (off-state) may degrade. Also, the interference pattern may vary according to the shape of subpixels and the interval between subpixels. For example, because the high-resolution display apparatus 1 has a small interval between the subpixels, the interference pattern due to the diffraction of lights reflected from the subpixels may increase.

However, in the display apparatus 1 of the disclosure, at least some of the reflected lights generating an interference pattern may be set to have a corresponding phase difference therebetween, and thus, the high-resolution display apparatus 1 may have a double image reduction effect equivalent to that of the low-resolution display apparatus. For example, an interference pattern may be generated by the lights reflected from the subpixels of the same color, for example, by the lights reflected from the green subpixels Pg, the lights reflected from the red subpixels Pr, or the lights reflected from the blue subpixels Pb. Also, the subpixels of the same color generating an interference pattern may be arranged adjacent to each other. The display apparatus 1 of the disclosure may include a phase difference pattern structure in which at least some of the lights reflected from the subpixels of the same color have a corresponding phase difference therebetween.

Referring to the subpixel arrangement structure of FIG. 5, for example, at least some of the lights respectively reflected from four green subpixels Pg arranged at the vertexes of a virtual square VSG having a blue subpixel Pb as a center point may have different phases. At least some of the lights respectively reflected from four blue subpixels Pb arranged at the vertexes of a virtual square VSB having a red subpixel Pr as a center point may have different phases. At least some of the lights respectively reflected from four red subpixels Pr arranged at the vertexes of a virtual square VSR having a blue subpixel Pb as a center point may have different phases.

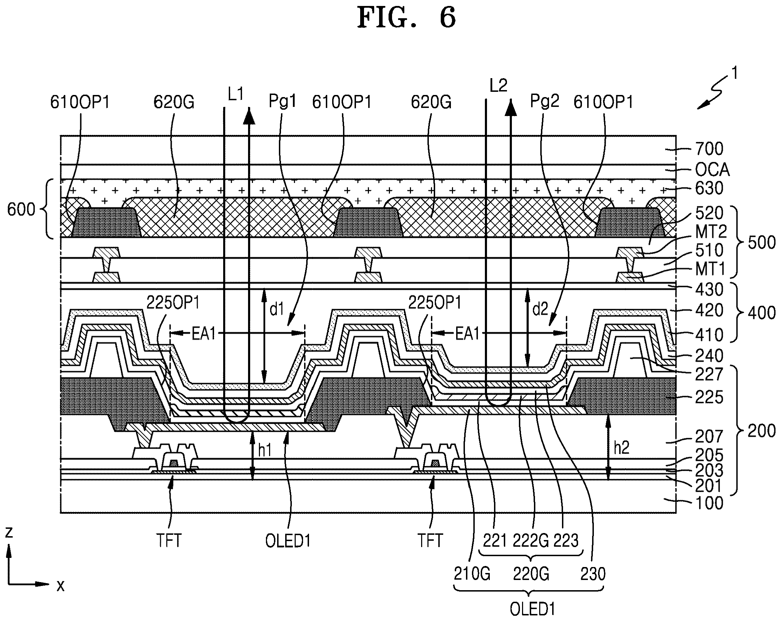

The phase difference pattern structure included in the display apparatus 1 of the disclosure will be described below in detail with reference to FIGS. 6 to 9.

FIG. 6 is a cross-sectional view schematically illustrating a portion of a display apparatus according to one or more embodiments. Hereinafter, the phase difference pattern structure will be described based on the green subpixels Pg. However, the same structure may also be applied to the red subpixels Pr and the blue subpixel Pb and redundant descriptions thereof will be omitted for conciseness.

Referring to FIG. 6, in one or more embodiments, a plurality of subpixels of the display apparatus 1 may include a first green subpixel Pg1 and a second green subpixel Pg2. The first green subpixel Pg1 and the second green subpixel Pg2 may be arranged adjacent to each other. In one or more embodiments, the first green subpixel Pg1 may be referred to as a (1-1)th color subpixel, and the second green subpixel Pg2 may be referred to as a (1-2)th color subpixel.

Each of the first green subpixel Pg1 and the second green subpixel Pg2 may include a subpixel electrode 210G, an intermediate layer 220G, and an opposite electrode 230 constituting the first organic light-emitting diode OLED1. The light reflected from each subpixel may be the light reflected by a metal layer of each subpixel, for example, a subpixel electrode or an opposite electrode. For example, first light L1 may be the light reflected from a subpixel electrode 210G of the first green subpixel Pg1. Second light L2 may be the light reflected from a subpixel electrode 210G of the second green subpixel Pg2.

A vertical distance h1 from the substrate 100 to the subpixel electrode 210G of the first green subpixel Pg1 may be different from a vertical distance h2 from the substrate 100 to the subpixel electrode 210G of the second green subpixel Pg2. For example, the vertical distance h1 from the substrate 100 to the subpixel electrode 210G of the first green subpixel Pg1 may be less than the vertical distance h2 from the substrate 100 to the subpixel electrode 210G of the second green subpixel Pg2.

In one or more embodiments, the thickness of a portion of the planarization layer 207 corresponding to the first green subpixel Pg1 may be different from the thickness of a portion of the planarization layer 207 corresponding to the second green subpixel Pg2. For example, the thickness of a portion of the planarization layer 207 corresponding to the first green subpixel Pg1 may be less than the thickness of a portion of the planarization layer 207 corresponding to the second green subpixel Pg2.

In other words, with respect to the substrate 100, the height of the subpixel electrode 210G of the first green subpixel Pg1 may be different from the height of the subpixel electrode 210G of the second green subpixel Pg2. For example, the height of the subpixel electrode 210G of the first green subpixel Pg1 may be less than the height of the subpixel electrode 210G of the second green subpixel Pg2. Thus, the first light L1 and the second light L2 respectively reflected from the subpixel electrodes 210G of the first green subpixel Pg1 and the second green subpixel Pg2 may have different movement paths. For example, the movement path of the first light L1 may be longer than the movement path of the second light L2.

Because the heights of the subpixel electrodes 210G of the first green subpixel Pg1 and the second green subpixel Pg2 are different from each other, the thicknesses of the organic encapsulation layers 420 respectively covering the subpixel electrodes 210G of the first green subpixel Pg1 and the second green subpixel Pg2 may be different from each other. For example, a thickness d1 of a portion of the organic encapsulation layer 420 corresponding to the first green subpixel Pg1 may be greater than a thickness d2 of a portion of the organic encapsulation layer 420 corresponding to the second green subpixel Pg2. In other embodiment, the thickness d1 of a portion of the organic encapsulation layer 420 corresponding to the first green subpixel Pg1 may be smaller than a thickness d2 of a portion of the organic encapsulation layer 420 corresponding to the second green subpixel Pg2.

In the movement paths of the first light L1 and the second light L2, the thicknesses of the organic encapsulation layer 420 through which the first light L1 and the second light L2 pass may be different from each other. Accordingly, the first light L1 and the second light L2 may have a phase difference therebetween.

For example, when the first light L1 and the second light L2 have the same wavelength $\lambda$ in a vacuum and the refractive index of the organic encapsulation layer 420 is n0, the first light L1 and the second light L2 may respectively have phases as in Equation 1 and Equation 2 below while passing through the organic encapsulation layer 420.

Equation 1

$$\phi_1 = 2 \cdot \frac{2\pi}{\lambda} n0 \cdot d1$$

Equation 2

$$\phi_2 = 2 \cdot \frac{2\pi}{\lambda} n0 \cdot d2$$

Here, d1 is the thickness of a portion of the organic encapsulation layer 420 corresponding to the first green subpixel Pg1, and d2 is the thickness of a portion of the organic encapsulation layer 420 corresponding to the second green subpixel Pg2. For example, in one or more other embodiments, the thickness d1 of a portion of the organic encapsulation layer 420 corresponding to the first green subpixel Pg1 may be less than the thickness d2 of a portion of the organic encapsulation layer 420 corresponding to the second green subpixel Pg2.

Thus, the first light L1 reflected from the first green subpixel Pg1 and the second light L2 reflected from the second green subpixel Pg2 may have a phase difference therebetween. For example, the first light L1 and the second light L2 may have a phase difference therebetween as in Equation 3 below.

Equation 3

$$\Delta\phi_{21} = \phi_2 - \phi_1 = 2 \cdot \frac{2\pi}{\lambda} n0 \cdot \Delta d, \ (\Delta d = d2 - d1)$$

Here, $\Delta$d is the thickness difference between the portions of the organic encapsulation layer 420 through which the first light L1 and the second light L2 respectively pass, which may correspond to the difference between the height of the subpixel electrode 210G of the first green subpixel Pg1 and the height of the subpixel electrode 210G of the second green subpixel Pg2. In other words, the thickness difference $\Delta$d between the portions of the organic encapsulation layer 420 through which the first light L1 and the second light L2 respectively pass may correspond to the difference between the vertical distance h1 from the substrate 100 to the subpixel electrode 210G of the first green subpixel Pg1 and the vertical distance h2 from the substrate 100 to the subpixel electrode 210G of the second green subpixel Pg2.

In one or more embodiments, the first light L1 and the second light L2 passing through the first color filter 620G may have a wavelength λ of about 550 nm in a vacuum. The organic encapsulation layer 420 may have a refractive index (n0) of about 1.495. In this case, when the height difference between the subpixel electrodes 210G of the first green subpixel Pg1 and the second green subpixel Pg2 is designed to be about 276 nm, the first light L1 and the second light L2 may have a phase difference of about π therebetween.

As described above, at least some of the lights reflected from the green subpixels Pg included in the plurality of subpixels may have different phases. For convenience of description, FIG. 6 illustrates a case where the first light L1 and the second light L2 respectively reflected from two adjacent green subpixels, that is, the first green subpixel Pg1 and the second green subpixel Pg2, have a phase difference therebetween. The same structure may also be applied to the red subpixels Pr and the blue subpixels Pb.

In one or more embodiments, a plurality of subpixels may include a first blue subpixel and a second blue subpixel arranged adjacent to each other. In one or more embodiments, the first blue subpixel may be referred to as a (2-1)th color subpixel, and the second blue subpixel may be referred to as a (2-2)th color subpixel. The vertical distance from the substrate 100 to the subpixel electrode of the first blue subpixel may be different from the vertical distance from the substrate 100 to the subpixel electrode of the second blue subpixel. In other words, with respect to the substrate 100, the height of the subpixel electrode of the first blue subpixel may be different from the height of the subpixel electrode of the second blue subpixel. The light reflected from the first blue subpixel may have a phase difference with respect to the light reflected from the second blue subpixel.

In one or more embodiments, a plurality of subpixels may include a first red subpixel and a second red subpixel arranged adjacent to each other. In one or more embodiments, the first red subpixel may be referred to as a (3-1)th color subpixel, and the second red subpixel may be referred to as a (3-2)th color subpixel. The vertical distance from the substrate 100 to the subpixel electrode of the first red subpixel may be different from the vertical distance from the substrate 100 to the subpixel electrode of the second red subpixel. In other words, with respect to the substrate 100, the height of the subpixel electrode of the first red subpixel may be different from the height of the subpixel electrode of the second red subpixel. The light reflected from the first red subpixel may have a phase difference with respect to the light reflected from the second red subpixel.

In the subpixels having the same color, by differently adjusting the vertical distance from the substrate 100 to the subpixel electrode of each subpixel, that is, the height of the subpixel electrode of each subpixel with respect to the substrate 100, the lights respectively reflected from the subpixels may be designed to have a phase difference therebetween.

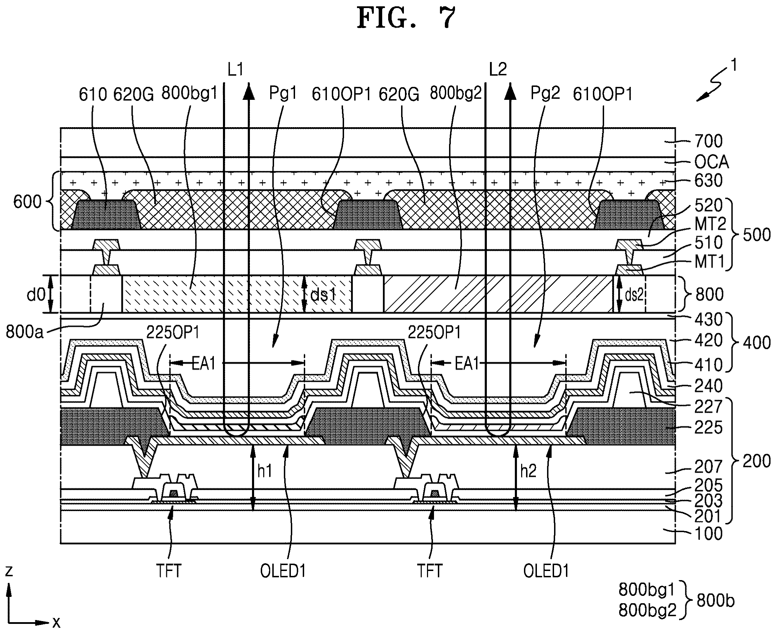

FIGS. 7 to 9 are cross-sectional views schematically illustrating a display apparatus according to other embodiments.

Referring to FIGS. 7 to 9, the display apparatus 1 may include a phase difference pattern layer 800. In one or more embodiments, the phase difference pattern layer 800 may be arranged between the encapsulation layer 400 and the touch sensor layer 500. However, the disclosure is not limited thereto. The phase difference pattern layer 800 may be arranged between a plurality of subpixels and the cover window 700. For example, the phase difference pattern layer 800 may be arranged between a plurality of color filters and the cover window 700. In one or more embodiments, the phase difference pattern layer 800 is included as a separate layer. However, the disclosure is not limited thereto. For example, the phase difference pattern layer 800 may be included in the adhesive layer OCA.

The phase difference pattern layer 800 may include a base portion 800a and a plurality of pattern portions 800b corresponding to each subpixel. The base portion 800a may be a portion other than the plurality of pattern portions 800b. For example, the base portion 800a may include a portion corresponding to a body portion of the light-blocking layer 610. In one or more embodiments, in the plan view, the base portion 800a may be arranged to surround each of the plurality of pattern portions 800b. In some embodiments, the base portion 800a may cover at least some of the plurality of pattern portions 800b to planarize the upper surface of the phase difference pattern layer 800. In one or more embodiments, among the plurality of pattern portions 800b and the base portion 800a, portions including the same material may be integrally provided.

In one or more embodiments, in the plan view, each of the plurality of pattern portions 800b may have a width (or size) that is greater than the width (or size) of the corresponding subpixel.

The phase difference pattern layer 800 may include a transparent material. In one or more embodiments, the phase difference pattern layer 800 may include a transparent organic insulating material or a transparent inorganic insulating material. In one or more embodiments, the phase difference pattern layer 800 may include an organic material with a band gap of about 3.2 eV or more. In one or more embodiments, the phase difference pattern layer 800 may include a material with a refractive index of about 1 to about 2.

In one or more embodiments, the phase difference pattern layer 800 may be arranged as a plurality of phase difference pattern layers. For example, the phase difference pattern layer 800 may be formed by sequentially stacking a first phase difference pattern layer and a second phase difference pattern layer.

Hereinafter, the phase difference pattern layer 800 will be described based on the green subpixels Pg. However, the same structure may also be applied to the red subpixels Pr and the blue subpixel Pb and redundant descriptions thereof will be omitted for conciseness.

Referring to FIGS. 7 to 9, the display apparatus 1 may include a first green subpixel Pg1 and a second green subpixel Pg2. The first green subpixel Pg1 and the second green subpixel Pg2 may be arranged adjacent to each other. In one or more embodiments, first light L1 may be the light reflected from a subpixel electrode 210G of the first green subpixel Pg1. Second light L2 may be the light reflected from a subpixel electrode 210G of the second green subpixel Pg2. A vertical distance h1 from the substrate 100 to the subpixel electrode 210G of the first green subpixel Pg1 may be equal to a vertical distance h2 from the substrate 100 to the subpixel electrode 210G of the second green subpixel Pg2.

The phase difference pattern layer 800 may include a first green pattern portion 800bg1 corresponding to the first green subpixel Pg1 and a second green pattern portion 800bg2 corresponding to the second green subpixel Pg2. The first green pattern portion 800bg1 and the second green pattern portion 800bg2 may be different from each other in at least one of refractive index or thickness. In one or more embodiments, the first green pattern portion 800bg1 may be referred to as a (1-1)th color pattern portion, and the second green pattern portion 800bg2 may be referred to as a (1-2)th color pattern portion.

Referring to FIG. 7, in one or more embodiments, the first green pattern portion 800bg1 and the second green pattern portion 800bg2 may include different materials with different refractive indexes. A thickness ds1 of the first green pattern portion 800bg1 may be equal to a thickness ds2 of the second green pattern portion 800bg2. The thickness ds1 of the first green pattern portion 800bg1 and the thickness ds2 of the second green pattern portion 800bg2 may be equal to a thickness d0 of the phase difference pattern layer 800.

In the movement paths of the first light L1 and the second light L2, the refractive indexes of the pattern portions 800b of the phase difference pattern layer 800 through which the first light L1 and the second light L2 pass may be different from each other. Accordingly, the first light L1 and the second light L2 may have a phase difference therebetween.

For example, the first light L1 and the second light L2 may have the same wavelength $\lambda$ in a vacuum, and the thickness ds1 of the first green pattern portion 800bg1 and the thickness ds2 of the second green pattern portion 800bg2 may be equal to the thickness d0 of the phase difference pattern layer 800. The first light L1 and the second light L2 may respectively have phases in Equation 4 and Equation 5 below while passing through the phase difference pattern layer 800.

Equation 4

$$\phi_1 = 2 \cdot \frac{2\pi}{\lambda} n1 \cdot d0$$

Equation 5

$$\phi_2 = 2 \cdot \frac{2\pi}{\lambda} n2 \cdot d0$$

Here, n1 is the refractive index of the first green pattern portion 800bg1, and n2 is the refractive index of the second green pattern portion 800bg2. The refractive index n1 may be different from the refractive index n2. For example, the refractive index n1 may be greater than the refractive index n2.

Thus, the first light L1 reflected from the first green subpixel Pg1 and the second light L2 reflected from the second green subpixel Pg2 may have a phase difference therebetween. For example, the first light L1 and the second light L2 may have a phase difference therebetween as in Equation 6 below.

Equation 6

$$\Delta\phi_{12} = \phi_1 - \phi_2 = 2 \cdot \frac{2\pi}{\lambda} \Delta n \cdot d0, \ (\Delta n = n1 - n2)$$

Here, $\Delta n$ corresponds to the refractive index difference between the first green pattern portion 800bg1 and the second green pattern portion 800bg2 through which the first light L1 and the second light L2 respectively pass.

In one or more embodiments, the first light L1 and the second light L2 passing through the first color filter 620G may have a wavelength $\lambda$ of about 550 nm. The first green pattern portion 800bg1 may have the same refractive index n1 of 1.9 as the base portion 800a, and the second green pattern portion 800bg2 may have a refractive index n2 of 1.5. The thickness ds1 of the first green pattern portion 800bg1 and the thickness ds2 of the second green pattern portion 800bg2 may be equal to the thickness d0 of the phase difference pattern layer 800.

In this case, when the thickness d0 of the phase difference pattern layer 800 is designed to be about 343.78 nm, the first light L1 and the second light L2 may have a phase difference of about $\pi$ therebetween. When the thickness d0 of the phase difference pattern layer 800 is designed to be about 171.9 nm, the first light L1 and the second light L2 may have a phase difference of about $0.5\pi$ therebetween. When the thickness d0 of the phase difference pattern layer 800 is designed to be about 515.6 nm, the first light L1 and the second light L2 may have a phase difference of about $1.5\pi$ therebetween. As the thickness d0 of the phase difference pattern layer 800 is adjusted, the phase difference between the first light L1 and the second light L2 may be adjusted within a range of more than about 0 and less than about $2\pi$.

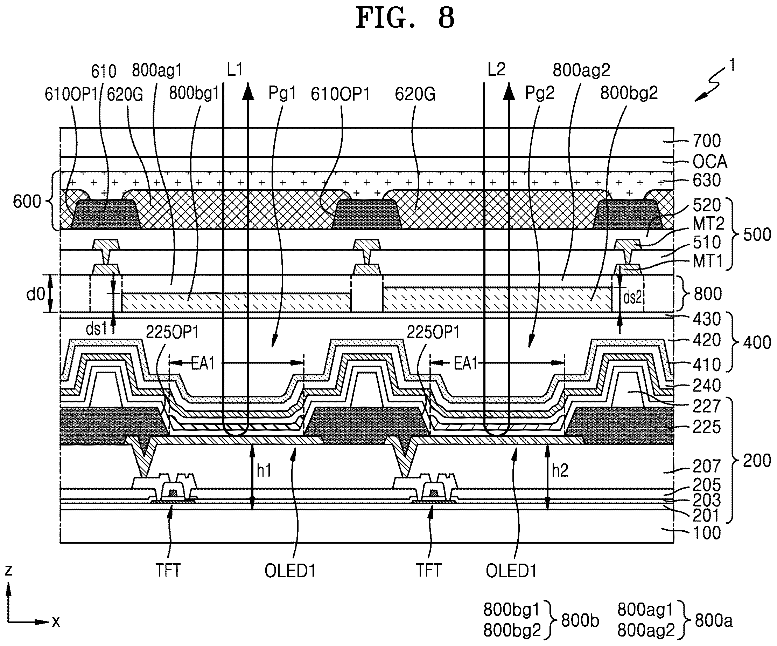

Referring to FIG. 8, in one or more embodiments, the first green pattern portion 800bg1 and the second green pattern portion 800bg2 may include the same material with the same refractive index. The thickness ds1 of the first green pattern portion 800bg1 may be different from the thickness ds2 of the second green pattern portion 800bg2. The thickness ds1 of the first green pattern portion 800bg1 and the thickness ds2 of the second green pattern portion 800bg2 may be equal to or less than the thickness d0 of the phase difference pattern layer 800. For example, the thickness ds1 of the first green pattern portion 800bg1 and the thickness ds2 of the second green pattern portion 800bg2 may be less than the thickness d0 of the phase difference pattern layer 800.

In the movement paths of the first light L1 and the second light L2, the thicknesses of the pattern portions 800b of the phase difference pattern layer 800 through which the first light L1 and the second light L2 pass may be different from each other. Accordingly, the first light L1 and the second light L2 may have a phase difference therebetween.

For example, when the first light L1 and the second light L2 have the same wavelength $\lambda$ in a vacuum, the first green pattern portion 800bg1 and the second green pattern portion 800bg2 have the same refractive index n, and the refractive index of the base portion 800a is nb, the first light L1 and the second light L2 may respectively have phases as in Equation 7 and Equation 8 below while passing through the phase difference pattern layer 800.

Equation 7

$$\phi_1 = 2 \cdot \frac{2\pi}{\lambda} n \cdot ds1 + 2 \cdot \frac{2\pi}{\lambda} nb \cdot (d0 - ds1)$$

Equation 8

$$\phi_2 = 2 \cdot \frac{2\pi}{\lambda} n \cdot ds2 + 2 \cdot \frac{2\pi}{\lambda} nb \cdot (d0 - ds2)$$

Here, ds1 is the thickness of the first green pattern portion 800bg1, and ds2 is the thickness of the second green pattern portion 800bg2. For example, the thickness ds1 of the first green pattern portion 800bg1 may be less than the thickness ds2 of the second green pattern portion 800bg2. A value equal to d0 - ds1 may also be equal to the thickness of a portion 800ag1 of the base portion 800a overlapping the first green subpixel Pg1, and a value equal to d0 - ds2 may also be equal to the thickness of a portion 800ag2 of the base portion 800a overlapping the second green subpixel Pg2.

Thus, the first light L1 reflected from the first green subpixel Pg1 and the second light L2 reflected from the second green subpixel Pg2 may have a phase difference therebetween. For example, the first light L1 and the second light L2 may have a phase difference therebetween as in Equation 9 below.

Equation 9

$$\Delta\phi_{21} = \phi_2 - \phi_1 = 2 \cdot \frac{2\pi}{\lambda} (n - nb) \cdot \Delta ds, \ (\Delta ds = ds2 - ds1)$$

Here, $\Delta$ds corresponds to the thickness difference between the first green pattern portion 800bg1 and the second green pattern portion 800bg2 through which the first light L1 and the second light L2 respectively pass.

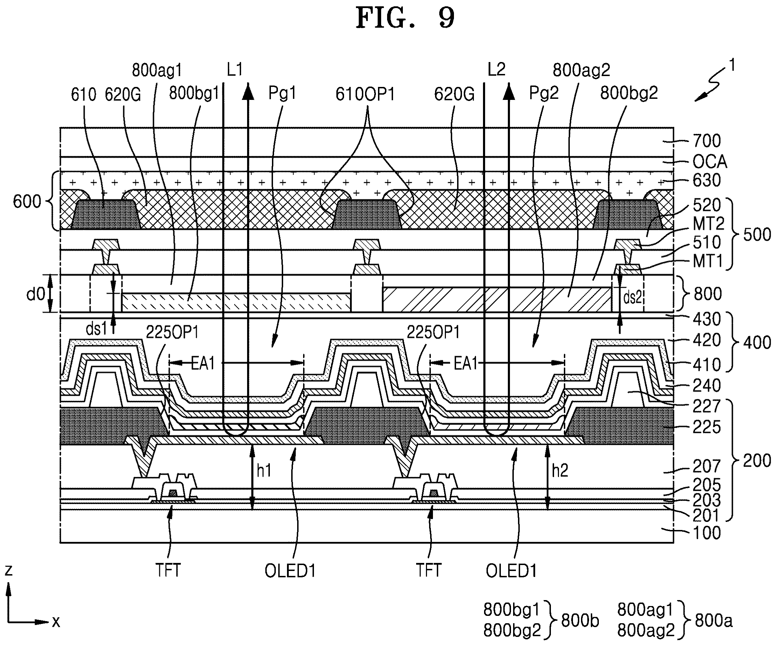

Referring to FIG. 9, in one or more embodiments, the first green pattern portion 800bg1 and the second green pattern portion 800bg2 may include different materials with different refractive indexes. The thickness ds1 of the first green pattern portion 800bg1 may be different from the thickness ds2 of the second green pattern portion 800bg2. The thickness ds1 of the first green pattern portion 800bg1 and the thickness ds2 of the second green pattern portion 800bg2 may be equal to or less than the thickness d0 of the phase difference pattern layer 800.

In the movement paths of the first light L1 and the second light L2, the refractive indexes and thicknesses of the pattern portions 800b of the phase difference pattern layer 800 through which the first light L1 and the second light L2 pass may be different from each other. Accordingly, the first light L1 and the second light L2 may have a phase difference therebetween.

For example, when the first light L1 and the second light L2 have the same wavelength $\lambda$ in a vacuum, the first light L1 and the second light L2 may respectively have phases as in Equation 10 and Equation 11 below while passing through the phase difference pattern layer 800.

Equation 10

$$\phi_1 = 2 \cdot \frac{2\pi}{\lambda} n1 \cdot ds1 + 2 \cdot \frac{2\pi}{\lambda} nb \cdot (d0 - ds1)$$

Equation 11

$$\phi_2 = 2 \cdot \frac{2\pi}{\lambda} n2 \cdot ds2 + 2 \cdot \frac{2\pi}{\lambda} nb \cdot (d0 - ds2)$$

Here, n1 is the refractive index of the first green pattern portion 800bg1, and n2 is the refractive index of the second green pattern portion 800bg2. The refractive index n1 may be different from the refractive index n2. For example, the refractive index n1 may be greater than the refractive index n2. Also, ds1 is the thickness of the first green pattern portion 800bg1, and ds2 is the thickness of the second green pattern portion 800bg2. For example, the thickness ds1 of the first green pattern portion 800bg1 may be less than the thickness ds2 of the second green pattern portion 800bg2. A value equal to d0 - ds1 may also be equal to the thickness of a portion 800ag1 of the base portion 800a overlapping the first green subpixel Pg1, and a value equal to d0 - ds2 may also be equal to the thickness of a portion 800ag2 of the base portion 800a overlapping the second green subpixel Pg2.

Thus, the first light L1 reflected from the first green subpixel Pg1 and the second light L2 reflected from the second green subpixel Pg2 may have a phase difference therebetween. For example, the first light L1 and the second light L2 may have a phase difference therebetween as in Equation 12 below.

Equation 12

$$\Delta\phi_{21} = \phi_2 - \phi_1 = 2 \cdot \frac{2\pi}{\lambda}(n2 \cdot ds2 - n1 \cdot ds1 - nb(ds2 - ds1))$$

As described above, at least some of the lights reflected from the green subpixels Pg included in the plurality of subpixels may have different phases. For convenience of description, FIGS. 7 to 9 illustrate a case where the first light L1 and the second light L2 respectively reflected from two adjacent green subpixels, that is, the first green subpixel Pg1 and the second green subpixel Pg2 have a phase difference therebetween. The same structure may also be applied to the red subpixels Pr and the blue subpixels Pb.

In one or more embodiments, a plurality of subpixels may include a first blue subpixel and a second blue subpixel arranged adjacent to each other. A plurality of pattern portions of the phase difference pattern layer 800 may include a first blue pattern portion corresponding to the first blue subpixel and a second blue pattern portion corresponding to the second blue subpixel. The first blue pattern portion and the second blue pattern portion may be different from each other in at least one of refractive index or thickness. The light reflected from the first blue subpixel may have a phase difference with respect to the light reflected from the second blue subpixel. In one or more embodiments, the first blue pattern portion may be referred to as a (2-1)th color pattern portion, and the second blue pattern portion may be referred to as a (2-2)th color pattern portion.

In one or more embodiments, a plurality of subpixels may include a first red subpixel and a second red subpixel arranged adjacent to each other. A plurality of pattern portions of the phase difference pattern layer 800 may include a first red pattern portion corresponding to the first red subpixel and a second red pattern portion corresponding to the second red subpixel. The first red pattern portion and the second red pattern portion may be different from each other in at least one of refractive index or thickness. The light reflected from the first red subpixel may have a phase difference with respect to the light reflected from the second red subpixel. In one or more embodiments, the first red pattern portion may be referred to as a (3-1)th color pattern portion, and the second red pattern portion may be referred to as a (3-2)th color pattern portion.

According to the embodiments of FIGS. 7 to 9, because at least one of the refractive indexes or thicknesses of the pattern portions 800b of the phase difference pattern layer 800, through which the lights reflected from subpixels having the same color pass, are set to be different from each other, the lights reflected from the subpixels may be set to have a phase difference therebetween.

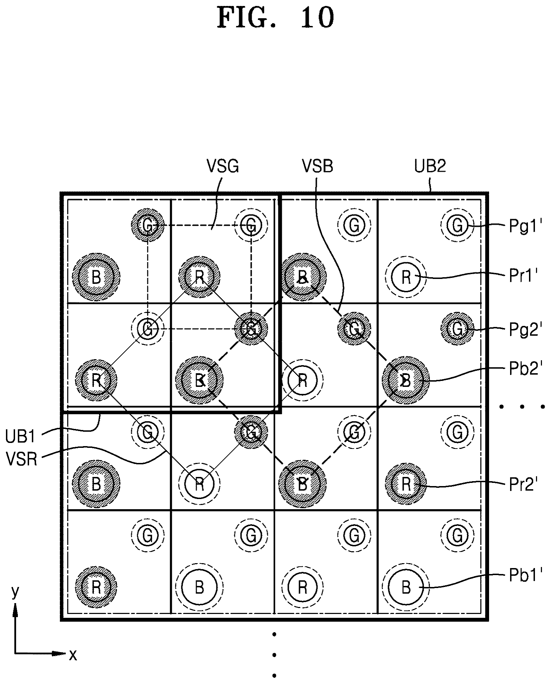

FIG. 10 is a plan view illustrating a portion of a display apparatus according to one or more embodiments. FIG. 10 is an example diagram and illustrates that the lights respectively reflected from the plurality of subpixels are designed to have a phase difference therebetween by using the phase difference pattern structure described above with reference to FIGS. 6 to 9.

Referring to FIG. 10, for example, the light reflected from a second red subpixel Pr2' may have a phase difference of $0.5\pi$ with respect to the light reflected from a first red subpixel Pr1'. The light reflected from a second blue subpixel Pb2' may have a phase difference of $0.5\pi$ with respect to the light reflected from a first blue subpixel Pb1'. The light reflected from a second green subpixel Pg2' may have a phase difference of about $0.5\pi$ with respect to the light reflected from a first green subpixel Pg1'.

In FIG. 10, the lights reflected from the subpixels of the same color are designed to have a phase difference of about 0 or about $0.5\pi$ therebetween. However, the disclosure is not limited thereto. In other embodiments, the lights reflected from the subpixels of the same color may be designed to have a phase difference of about 0, about $0.5\pi$, about $\pi$, or about $1.5\pi$ therebetween.

At least some of the lights respectively reflected from four green subpixels arranged at the vertexes of a virtual square VSG may have a phase difference of about $0.5\pi$ therebetween. At least some of the lights respectively reflected from four blue subpixels arranged at the vertexes of a virtual square VSB may have a phase difference of about $0.5\pi$ therebetween. Also, at least some of the lights respectively reflected from four red subpixels arranged at the vertexes of a virtual square VSR may have a phase difference of about $0.5\pi$ therebetween.

The disclosure may reduce the interference pattern generated by the lights reflected from the subpixels of the same color, by differently adjusting the phase difference of the light reflected for each position of each subpixel among the subpixels of the same color by using the phase difference pattern structure. The phase difference pattern may be designed in an optimized form that may reduce or minimize the interference pattern.

The phase difference pattern structure corresponding to the plurality of subpixels included in the display apparatus may include a repeated arrangement structure of a phase difference pattern unit block UB2. The phase difference pattern unit block UB2 may be a virtual unit block having a corresponding area including a phase difference pattern structure corresponding to each of red subpixels, blue subpixels, and green subpixels and may be understood as corresponding to a minimum repetition unit of the arrangement pattern of the phase difference pattern structure included in the display apparatus. In one or more embodiments, the phase difference pattern unit block UB2 may have a tetragonal shape. For example, the phase difference pattern unit block UB2 may have a square shape.

The size of the phase difference pattern unit block UB2 may be greater than the size of the subpixel pattern unit block UB1. The subpixels corresponding to the phase difference pattern unit block UB2 may have a structure in which K (K is a natural number greater than 0) subpixel pattern unit blocks are arranged in a first direction (e.g., first direction x), and in which K (K is a natural number greater than 0) subpixel pattern unit blocks are arranged in a second direction (e.g., second direction y) that is perpendicular to the first direction.

According to the above embodiments, a high-resolution display apparatus having an excellent display quality in a display state (on-state) while being improved in the interference pattern due to reflection and diffraction of external light in a non-display state (off-state) is provided. However, the scope of the disclosure is not limited to these effects.

It should be understood that embodiments described herein should be considered in a descriptive sense only and not for purposes of limitation. Descriptions of aspects within each embodiment should typically be considered as available for other similar aspects in other embodiments. While one or more embodiments have been described with reference to the figures, it will be understood by those of ordinary skill in the art that various changes in form and details may be made therein without departing from the spirit and scope as defined by the following claims, with functional equivalents thereof to be included therein.

## Claims

1.   A display apparatus comprising:

a substrate;
subpixels comprising:

first color subpixels comprising a (1-1)th color subpixel and a (1-2)th color subpixel for emitting light of a same color, light reflected from the (1-1)th color subpixel having a phase difference with respect to light reflected from the (1-2)th color subpixel;
second color subpixels; and
third color subpixels, each of the subpixels comprising a subpixel electrode, an emission layer over the subpixel electrode, and an opposite electrode over the emission layer;
a bank layer defining lower opening portions defining an emission area in each of the subpixels;
a light-blocking layer above the bank layer, and defining upper opening portions respectively overlapping the lower opening portions; and
color filters above the light-blocking layer, and comprising first color filters, second color filters, and third color filters.

2.   The display apparatus of claim 1, wherein

the second color subpixels comprise a (2-1)th color subpixel and a (2-2)th color subpixel for emitting light of a same color, and
wherein light reflected from the (2-1)th color subpixel has a phase difference with respect to light reflected from the (2-2)th color subpixel.

3. The display apparatus of claim 2, wherein

the third color subpixels comprise a (3-1)th color subpixel and a (3-2)th color subpixel for emitting light of a same color, and
wherein light reflected from the (3-1)th color subpixel has a phase difference with respect to light reflected from the (3-2)th color subpixel.

4. The display apparatus of claim 1, wherein
the light reflected from the (1-1)th color subpixel and the light reflected from the (1-2)th color subpixel have a same wavelength in a vacuum.

5. The display apparatus of claim 1, wherein
the light reflected from the (1-1)th color subpixel and the light reflected from the (1-2)th color subpixel have a phase difference therebetween greater than about 0 and less than about $2\pi$.

6. The display apparatus of claim 1, wherein
a vertical distance from the substrate to the subpixel electrode of the (1-1)th color subpixel is different from a vertical distance from the substrate to the subpixel electrode of the (1-2)th color subpixel.

7. The display apparatus of claim 2, wherein
a vertical distance from the substrate to the subpixel electrode of the (2-1)th color subpixel is different from a vertical distance from the substrate to the subpixel electrode of the (2-2)th color subpixel.

8. The display apparatus of claim 3, wherein
a vertical distance from the substrate to the subpixel electrode of the (3-1)th color subpixel is different from a vertical distance from the substrate to the subpixel electrode of the (3-2)th color subpixel.

9. The display apparatus of claim 3, wherein

the (1-1)th color subpixel and the (1-2)th color subpixel are adjacent to each other,
wherein the (2-1)th color subpixel and the (2-2)th color subpixel are adjacent to each other, and
wherein the (3-1)th color subpixel and the (3-2)th color subpixel are adjacent to each other.

10. The display apparatus of claim 1, further comprising

a phase difference pattern layer above the bank layer, and comprising pattern portions respectively corresponding to the subpixels,
wherein the pattern portions comprise a (1-1)th color pattern portion corresponding to the (1-1)th color subpixel, and a (1-2)th color pattern portion corresponding to the (1-2)th color subpixel and different from the (1-1)th color pattern portion with respect to at least one of refractive index or thickness.

11. The display apparatus of claim 10, wherein
the (1-1)th color pattern portion and the (1-2)th color pattern portion respectively comprise different materials with different refractive indexes.

12. The display apparatus of claim 10, wherein

the (1-1)th color pattern portion and the (1-2)th color pattern portion comprise a same material, and
wherein a thickness of the (1-1)th color pattern portion is different from a thickness of the (1-2)th color pattern portion.

13. The display apparatus of claim 10, wherein

the (1-1)th color pattern portion and the (1-2)th color pattern portion respectively comprise different materials with different refractive indexes, and

wherein a thickness of the (1-1)th color pattern portion is different from a thickness of the (1-2)th color pattern portion.

14. The display apparatus of claim 10, wherein

the second color subpixels comprise a (2-1)th color subpixel and a (2-2)th color subpixel for emitting light of a same color,

wherein light reflected from the (2-1)th color subpixel has a phase difference with respect to light reflected from the (2-2)th color subpixel, and

wherein the pattern portions further comprise a (2-1)th color pattern portion corresponding to the (2-1)th color subpixel, and a (2-2)th color pattern portion corresponding to the (2-2)th color subpixel and different from the (2-1)th color pattern portion with respect to at least one of refractive index or thickness.

15. The display apparatus of claim 10, wherein

the third color subpixels comprise a (3-1)th color subpixel and a (3-2)th color subpixel for emitting light of a same color,

wherein light reflected from the (3-1)th color subpixel has a phase difference with respect to light reflected from the (3-2)th color subpixel, and

wherein the pattern portions further comprise a (3-1)th color pattern portion corresponding to the (3-1)th color subpixel and a (3-2)th color pattern portion corresponding to the (3-2)th color subpixel and different from the (3-1)th color pattern portion with respect to at least one of refractive index or thickness.

16. The display apparatus of claim 10, wherein
each of the pattern portions has a width that is greater than a width of a corresponding subpixel among the subpixels.

17. The display apparatus of claim 10, wherein
the pattern portions comprise an organic insulating material or an inorganic insulating material.

18. The display apparatus of claim 10, further comprising:

an encapsulation layer over the subpixels and the bank layer; and
a touch sensor layer over the encapsulation layer,
wherein the phase difference pattern layer is between the encapsulation layer and the touch sensor layer.

19. The display apparatus of claim 10, further comprising

a cover window over the color filters,
wherein the phase difference pattern layer is between the subpixels and the cover window.

20. A display apparatus comprising:

a substrate;
subpixels comprising:

first color subpixels comprising a (1-1)th color subpixel and a (1-2)th color subpixel for emitting light of a same color;
second color subpixels; and
third color subpixels, each of the subpixels comprising a subpixel electrode, an emission layer over the subpixel electrode, and an opposite electrode over the emission layer;
a bank layer defining lower opening portions defining an emission area of each of the subpixels;
a light-blocking layer above the bank layer, and defining upper opening portions respectively overlapping the lower opening portions;
color filters above the light-blocking layer, and comprising first color filters, second color filters, and third color filters; and
a phase difference pattern layer above the bank layer, and comprising pattern portions respectively corresponding to the subpixels, the pattern portions comprising a (1-1)th color pattern portion corresponding to the (1-1)th color subpixel, and a (1-2)th color pattern portion corresponding to the (1-2)th color subpixel and different from the (1-1)th color pattern portion with respect to at least one of refractive index or thickness.

# FIG. 1

# FIG. 2

# FIG. 3

# FIG. 4

EP 4 694 649 A1

# FIG. 5

# FIG. 6

EP 4 694 649 A1

# FIG. 7

EP 4 694 649 A1

# FIG. 8

EP 4 694 649 A1

# FIG. 9

# FIG. 10

## INTERNATIONAL SEARCH REPORT

| International application No. |
| --- |
| **PCT/KR2024/003578** |

### A. CLASSIFICATION OF SUBJECT MATTER

**H10K 59/35**(2023.01)i; **H10K 59/80**(2023.01)i; **H10K 59/38**(2023.01)i; **H10K 77/10**(2023.01)i; **H10K 59/122**(2023.01)i; **H10K 59/40**(2023.01)i

According to International Patent Classification (IPC) or to both national classification and IPC

### B. FIELDS SEARCHED

Minimum documentation searched (classification system followed by classification symbols)

H10K 59/35(2023.01); G02B 5/30(2006.01); G02F 1/13363(2006.01); H01L 27/15(2006.01); H01L 27/32(2006.01); H01L 51/52(2006.01); H10K 50/80(2023.01); H10K 59/00(2023.01); H10K 71/00(2023.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 표시장치(display), 부화소(sub pixel), 반사(reflection), 위상차(phase difference), 굴절(refraction)

### C. DOCUMENTS CONSIDERED TO BE RELEVANT

| Category* | Citation of document, with indication, where appropriate, of the relevant passages | Relevant to claim No. |
| --- | --- | --- |
| Y | KR 10-2020-0021275 A (SAMSUNG ELECTRONICS CO., LTD.) 28 February 2020 (2020-02-28) See paragraphs [0036]-[0072]; and figures 1-2 and 13. | 1-20 |
| Y | KR 10-2018-0036466 A (LG DISPLAY CO., LTD.) 09 April 2018 (2018-04-09) See paragraphs [0037]-[0182]; and figures 1 and 17-18. | 1-20 |
| Y | US 2012-0299002 A1 (KINOSHITA, Masaru) 29 November 2012 (2012-11-29) See paragraphs [0051]-[0053]; and figure 3. | 6-8 |
| Y | KR 10-2010-0096216 A (TOPPAN PRINTING CO., LTD.) 01 September 2010 (2010-09-01) See paragraphs [0032]-[0047]; and figures 1-2. | 10-20 |
| A | KR 10-2021-0111626 A (SAMSUNG ELECTRONICS CO., LTD.) 13 September 2021 (2021-09-13) See paragraphs [0044]-[0047]; and figure 1. | 1-20 |

☐ Further documents are listed in the continuation of Box C.  ☑ See patent family annex.

| | |
| --- | --- |
| * Special categories of cited documents: | "T" later document published after the international filing date or priority date and not in conflict with the application but cited to understand the principle or theory underlying the invention |
| "A" document defining the general state of the art which is not considered to be of particular relevance | |
| "D" document cited by the applicant in the international application | "X" document of particular relevance; the claimed invention cannot be considered novel or cannot be considered to involve an inventive step when the document is taken alone |
| "E" earlier application or patent but published on or after the international filing date | |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
| --- | --- |
| **20 June 2024** | **21 June 2024** |

| Name and mailing address of the ISA/KR | Authorized officer |
| --- | --- |
| **Korean Intellectual Property Office Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

**EP 4 694 649 A1**

| INTERNATIONAL SEARCH REPORT | International application No. |
| Information on patent family members | PCT/KR2024/003578 |

| Patent document cited in search report | | | Publication date (day/month/year) | Patent family member(s) | | | Publication date (day/month/year) |
|---|---|---|---|---|---|---|---|
| KR | 10-2020-0021275 | A | 28 February 2020 | CN | 110854286 | A | 28 February 2020 |
| | | | | EP | 3614447 | A1 | 26 February 2020 |
| | | | | EP | 3614447 | B1 | 27 April 2022 |
| | | | | KR | 10-2607862 | B1 | 29 November 2023 |
| | | | | US | 10950823 | B2 | 16 March 2021 |
| | | | | US | 11563199 | B2 | 24 January 2023 |
| | | | | US | 2020-0058905 | A1 | 20 February 2020 |
| | | | | US | 2021-0151716 | A1 | 20 May 2021 |
| KR | 10-2018-0036466 | A | 09 April 2018 | CN | 107887522 | A | 06 April 2018 |
| | | | | CN | 107887522 | B | 19 November 2019 |
| | | | | KR | 10-2630256 | B1 | 25 January 2024 |
| | | | | US | 10474279 | B2 | 12 November 2019 |
| | | | | US | 2018-0095581 | A1 | 05 April 2018 |
| US | 2012-0299002 | A1 | 29 November 2012 | CN | 101661951 | A | 03 March 2010 |
| | | | | CN | 101661951 | B | 15 June 2011 |
| | | | | EP | 2159843 | A2 | 03 March 2010 |
| | | | | EP | 2159843 | A3 | 01 May 2013 |
| | | | | EP | 2159843 | B1 | 15 April 2020 |
| | | | | EP | 3694002 | A1 | 12 August 2020 |
| | | | | JP | 2010-056017 | A | 11 March 2010 |
| | | | | JP | 5117326 | B2 | 16 January 2013 |
| | | | | US | 2010-0052524 | A1 | 04 March 2010 |
| | | | | US | 8237360 | B2 | 07 August 2012 |
| | | | | US | 8513882 | B2 | 20 August 2013 |
| KR | 10-2010-0096216 | A | 01 September 2010 | CN | 101910889 | A | 08 December 2010 |
| | | | | CN | 101910889 | B | 13 March 2013 |
| | | | | CN | 101946194 | A | 12 January 2011 |
| | | | | CN | 101946194 | B | 13 November 2013 |
| | | | | EP | 2261703 | A1 | 15 December 2010 |
| | | | | EP | 2261703 | A4 | 24 October 2012 |
| | | | | JP | 2010-033008 | A | 12 February 2010 |
| | | | | JP | 5110158 | B2 | 26 December 2012 |
| | | | | KR | 10-1216891 | B1 | 28 December 2012 |
| | | | | KR | 10-1266658 | B1 | 28 May 2013 |
| | | | | KR | 10-2010-0116676 | A | 01 November 2010 |
| | | | | US | 2011-0025952 | A1 | 03 February 2011 |
| | | | | US | 2011-0025953 | A1 | 03 February 2011 |
| | | | | US | 8284357 | B2 | 09 October 2012 |
| | | | | WO | 2009-122621 | A1 | 08 October 2009 |
| | | | | WO | 2009-123021 | A1 | 08 October 2009 |
| KR | 10-2021-0111626 | A | 13 September 2021 | CN | 113346030 | A | 03 September 2021 |
| | | | | EP | 3876284 | A1 | 08 September 2021 |
| | | | | EP | 3876284 | B1 | 22 November 2023 |
| | | | | US | 11653528 | B2 | 16 May 2023 |
| | | | | US | 2021-0280832 | A1 | 09 September 2021 |
| | | | | US | 2023-0247859 | A1 | 03 August 2023 |
| | | | | US | 2023-0247860 | A1 | 03 August 2023 |

Form PCT/ISA/210 (patent family annex) (July 2022)